# EUROPÄISCHE PATENTSCHRIFT

(11) **EP 1 987 395 B1**
(45) Veröffentlichungstag und Bekanntmachung des Hinweises auf die Patenterteilung: **28.12.2011**
(21) Anmeldenummer: 07845254.7
(22) Anmeldetag: 11.05.2007
(51) Int. Cl.: G03F 1/00, B29C 59/00, B44B 5/02

(54) **VERFAHREN ZUR OBERFLÄCHENSTRUKTURIERUNG EINES PRESSBLECHES ODER EINES ENDLOSBANDES**
METHOD FOR STRUCTURING THE SURFACE OF A PRESSED SHEET OR AN ENDLESS STRIP
PROCÉDÉ DE STRUCTURATION DE SURFACE D'UNE TÔLE EMBOUTIE OU D'UNE BANDE SANS FIN

(30) Priorität: 12.05.2006 DE 102006022722
(43) Veröffentlichungstag der Anmeldung: 05.11.2008
(73) Patentinhaber: Hueck Engraving GmbH & Co. KG, 41747 Viersen (DE)
(72) Erfinder: REICHERT, Jordi Fred, 58840 Plettenberg (DE)
(74) Vertreter: Demski, Siegfried
(86) Internationale Anmeldenummer: PCT/DE2007/000872
(87) Internationale Veröffentlichungsnummer: WO 2007/147376

(56) Entgegenhaltungen:
- WO-A-01/17794
- GB-A- 885 232
- GB-A- 1 567 442
- US-A- 4 269 679
- US-A- 5 183 551
- US-A- 5 495 803

## Beschreibung

Die Erfindung betrifft ein Verfahren zur Oberftächenstrukturierung eines Pressbleches oder eines Endlosbandes, wobei durch Auftragen einer Maske zur partiellen Passivierung mittels einer Vorrichtung eine Oberflächenstruktur vorgegeben und durch anschließende chemische Oberflächenbearbeitung hergestellt wird, sowie eine Vorrichtung zur Anwendung des Verfahrens.

Pressbleche und Endlosbänder werden nach dem Stand der Technik in der Form hergestellt, dass ein vorbehandeltes Blech beispielsweise mittels eines Siebdruckverfahrens oder einer Fotoschicht und anschließender Ätzung eine Oberflächenstruktur erhält. Der Siebdruck wird auf die großformatigen Bleche aufgebracht und anschließend werden die Bleche einer Oberflächenätzung unterzogen. Sämtliche Bereiche, welche die erhabene Oberflächenstruktur bilden, sind hierbei durch eine Maske abgedeckt, sodass eine Oberflächenätzung nur in den Bereichen erfolgt, die unmittelbar von der Ätzflüssigkeit angegriffen werden können. Die ausgeätzten Bereiche bilden sodann die Profiltäler der gewünschten Struktur. Nach erfolgter Ätzung wird die Oberfläche gereinigt und insbesondere die Maske entfernt, sodass durch weitere Arbeitsvorgänge die Oberfläche einem weiteren Vergütungsprozess, beispielsweise einer Hartverchromung, unterzogen werden kann.

Alternativ besteht die Möglichkeit, ein Fotoverfahren zu verwenden, bei dem zunächst eine fotoempfindliche Schicht aufgetragen wird. Diese muss anschließend entsprechend der vorgesehenen Maske zur Herstellung der Oberflächenstruktur belichtet werden. Danach ist eine Entwicklung der Fotoschicht erforderlich und zwischendurch müssen umfangreiche Spülvorgänge erfolgen, damit die Oberfläche für die nachfolgenden Arbeitsschritte vorbereitet und gereinigt werden kann. Nach Entwicklung der Fotoschicht entsteht so eine Maske, die als Ätzschablone verwendet werden kann. In diesem Verfahren wird also zunächst eine vollflächige Schicht aufgetragen, dann wird diese belichtet, darauf folgend von den nicht abgebundenen Bestandteilen befreit und dann erst kann die entwickelte Maske zum Ätzen einer Struktur verwendet werden. Die Reproduzierbarkeit der auf diesem Weg hergestellten Masken ist sehr schwierig und problematisch, weil das Negativ oder Positiv zur Belichtung der lichtempfindlichen Schicht immer dann exakt in der gleichen Position relativ zur fotoempfindlichen Schicht positioniert werden muss, wenn mehr als ein Belichtungs- und Ätzvorgang auf einander folgen sollen, um so komplexe dreidimensionale Strukturen auf die Oberfläche eines Pressbleches aufzubringen. Dies ist beispielsweise schon dann nicht mehr gegeben, wenn das Negativ oder Positiv zur Belichtung der lichtempfindlichen Schicht direkt auf diese aufgelegt wird und das Negativ oder Positiv nicht an jeder Stelle der fotoempfindlichen Schicht exakt den gleichen Abstand zu dieser aufweist. Die Reproduzierbarkeit des Aufbringens der Maske ist daher insbesondere beim Fotoverfahren zur Erzielung einer hohen Abbildungsgenauigkeit von besonderer Bedeutung. Die Schwierigkeiten können sich hierbei dann erhöhen, wenn eine dreidimensionale Struktur durch mehrere hintereinander laufende Belichtungs- und Ätzvorgänge erzielt werden soll und hierzu mehrere Masken nacheinander aufgetragen werden müssen, wobei zwischen jeder Maskenauftragung ein Ätzvorgang vorgenommen wird. Durch die genaue Positionierung und die erforderliche Anzahl von entsprechenden Masken ist somit die Herstellung der Pressbleche beziehungsweise Endlosbänder sehr aufwändig und kostenintensiv. Die Auflösung der aufzutragenden Maske ist hierbei sehr stark von dem verwendeten Verfahren abhängig und zudem sind eine erhebliche Anzahl von Arbeitsschritten erforderlich, die insbesondere durch die Größe der Pressbleche beziehungsweise Endlosbänder eine aufwändige Handhabung erfordern.

Darüber hinaus ist aus dem Stand der Technik bekannt, anstelle eines Siebdruckverfahrens eine Maske durch einen Wachsauftrag herzustellen, welcher gegen die verwendeten Ätzmittel chemisch resistent ist und somit eine Ätzung in den Bereichen ermöglicht, in denen die Oberfläche durch das Wachs nicht abgedeckt ist. Bei diesem Verfahren wird ein Druckkopf, welcher das Wachs auf die Oberfläche aufspritzt, entlang einer X- und Y-Achse verfahren, um die erforderliche Struktur durch eine Reihe von einzelnen Arbeitsgängen aufzutragen. In diesem Verfahren wird die Maske also direkt und ohne Umwege über Belichtung, Entwicklung und Entfernung der nicht entwickelten Schichtbestandteile auf das Pressblech aufgebracht. Prinzipiell können die verwendeten Druckköpfe ähnlich wie bei einem Tintenstrahldrucker aufgebaut sein, nur dass anstelle einer Tinte ein Wachs aufgesprüht wird, welches auf der Oberfläche der Pressbleche beziehungsweise Endlosbänder aushärtet und sodann kann die erforderliche Ätzung vorgenommen werden. Obwohl bei diesem Verfahren aus dem Stand der Technik ein enormer Fortschritt erzielt werden kann, hat es sich in der Praxis jedoch gezeigt, dass die Entfernung der Wachsschicht sehr problematisch ist, weil das Wachs sich nicht mit einer chemischen Behandlung entfernen lässt und somit die Reinigung der Bleche nach dem Ätzvorgang äußerst schwierig ist und beispielsweise nur mit einem Hochdruckreiniger durchgeführt werden kann. Auch bei dieser Bearbeitung ist ein hoher Zeitaufwand erforderlich und wenn mehrere Wachsschichten nacheinander aufgetragen werden sollen, wobei zwischen jeder Maskenauftragung ein Ätzvorgang vorgenommen wird, um beispielsweise eine Tiefenstruktur zu erreichen, können keine wesentlichen Vorteile erzielt werden. Aufgrund der Eigenschaften des Wachses ist der Genauigkeit und Strukturfeinheit der Maske eine Grenze gesetzt, sodass insbesondere feine Strukturen nicht aufgelöst werden können. Die Grenzen werden durch die rein physikalische Haftung durch Benetzung vorgegeben. Denn beim Aufsprühen des heißen und flüssigen Wachses auf das kalte Pressblech erstarrt das Wachs zu schnell und bildet unvollkommen benetzende Strukturen wie eine "kalte Lötstelle". Auch ein Beheizen der Pressplatte führt nicht zum Erfolg, weil dann das flüssige Wachs zerfließt und die erzielbare Auflösung verringert.

Aus der WO 01/17794 A1 ist ein Verfahren zur Bearbeitung einer Oberfläche für eine Prägaplatte bekannt, bei dem UV-Lack zum Auftragen einer Maske verwendet wird. Der UV-Lack wird durch eine UV-Lichtquelle ausgehärtet, sodass eine Ätzung der Prägaplatte erfolgen kann.

Aus dem US Patent 5,495,803 ist ferner eine Vorrichtung bekannt, welche die Möglichkeit des Auftragens beispielsweise eines UV-Lackes auf eine zu bearbeitende kleinformatige Oberfläche vorsieht. Bei dieser Vorrichtung wird ein Druckkopf über Antriebselemente in x- und y- Richtung verfahren, sodass eine Maske auf die zu bedruckende Oberfläche aufgetragen werden kann.

Von diesem Stand der Technik ausgehend liegt der vorliegenden Erfindung die Aufgabe zugrunde, ein Verfahren und eine Vorrichtung aufzuzeigen, mit der die Nachteile aus dem bekannten Stand der Technik vermieden werden und die Reproduzierbarkeit sowie Auflösung der erzielten Masken deutlich verbessert wird.

Erfindungsgemäß wird die gestellte Verfahrensaufgabe durch ein Verfahren mit dem folgenden Einzelschritten gelöst, die sich wie folgt darstellen:
- Lagerung des Pressbleches oder Endlosbandes auf einem Arbeitstisch mit einer planen Oberfläche zum Auftragen und Aushärten einer Maske,
- Auftragen einer aus zumindest teilweise aushärtbarem UV-Lack bestehenden Maske zur partiellen Passivierung durch eine geeignete Vorrichtung mittels eines digitalisierten Druckverfahrens,
- welche einen Sprühkopf umfasst der in einem geringen konstanten Abstand von 0,1 bis 4 mm zur Oberfläche der Pressbleche oder Endlosbänder geführt wird,
- zumindest teilweise Bestrahlung der Maske mit einer UV-Lichtquelle direkt nach der Auftragung zum Aushärten, vorzugsweise in einem Zeitraum von bis zu 60 Sekunden,
- chemisches Bearbeiten der Oberfläche des Pressbleches oder Endlosbandes.

Weitere vorteilhafte Ausgestaltungen ergeben sich aus den Unteransprüchen.

Vorzugsweise wird zum Auftragen des UV-Lacks ein Düsenkopf, verwendet, wobei der Düsenkopf mehrere Düsen aufweist, die in Form einer Matrix angeordnet sind und jeweils einzeln angesteuert werden können. Der Düsenkopf selbst wird in X- oder Y-Richtung in einer Ebene verfahrbar gehalten, sodass über eine EDV-untersfützte Steuereinheit, insbesondere eines PCs, ähnlich wie bei einem Plotter, der Düsenkopf in jede beliebige Richtung verfahren werden kann.

Erfindungsgemäß wird der Sprühkopf durch einen Stellmotor stets im gleichen Abstand vom Substrat gehalten, um geringfügige Verwerfungen der sehr großen Pressplatte auszugleichen. Zu diesem Zweck kann der Sprühkopf in der Höhe, dass heißt in z-Richtung verfahren werden. Hierbei wird darauf geachtet, dass der Düsenkopf in einem geringen Abstand von 0,1 - 4 mm, bevorzugt 0,8 mm, zur Oberfläche der Pressbleche oder Endlosbänder geführt wird. Die Bearbeitung kann hierbei in einer horizontalen oder vertikalen Position erfolgen, gegebenenfalls auch in einer geneigten Position, wobei die Pressbleche oder Endlosbänder auf einem Arbeitstisch gelagert werden, der eine plane Oberfläche aufweist und die Pressbleche zusätzlich durch ein Vakuum angesaugt werden, sodass eine unverrückbare Position der Pressbleche während des gesamten Bearbeitungsvorgangs gewährleistet ist. Hierbei ist insbesondere zu berücksichtigen, dass die Pressbleche derzeit bis zu 3 m Breite und bis zu 8 m Länge erreichen können und somit ein Auftragen der Maske einen gewissen Zeitumfang benötigt.

Ferner ist die Verwendung eines zumindest teilweise aushärtenden UV-Lackes für die Maske vorgesehen, wobei der UV-Lack mit der Vorrichtung aufgetragen und zumindest teilweise mit UV-Licht direkt nach der Auftragung, vorzugsweise in einem Zeitraum von bis zu 60 Sekunden zum Aushärten bestrahlt wird, wobei die Pressbleche oder Endlosbänder zur Bearbeitung auf einem Arbeitstisch mit einer planen Oberfläche gelagert werden.

Durch die Verwendung eines UV-aushärtenden Lackes und einer zum Auftragen vorgesehenen geeigneten Vorrichtung kann die erforderliche Maske vorzugsweise in einem, gegebenenfalls auch in mehreren Druck- und Ätzverfahren unmittelbar auf die Pressbleche oder Endlosbänder aufgetragen werden und es besteht die Möglichkeit, durch eine UV-Lichtquelle eine zumindest teilweise Aushärtung des UV-Lacks zu erreichen, sodass eine besonders gute Haftung auf der Oberfläche des Metalls gewährleistet ist. Darüber hinaus ist bei Transportvorgängen der Pressbleche beziehungsweise Endlosbänder sicher gestellt, dass die Verbindung zwischen Lack und Oberfläche des Metalls eine hohe Anhaftung gewährleistet, sodass bei dem anschließenden Ätzvorgang eine Unterätzung und damit Abweichungen zur vorgesehenen Oberflächenstruktur vermieden werden. Mittels eines Druckkopfes lässt sich der aushärtende Lack wesentlich genauer und vor allen Dingen präziser auf der Oberfläche auftragen und es kann bereits unmittelbar nach Auftragen des UV-beständigen Lackes eine Teilaushärtung vorgenommen werden, sodass ein Verwischen der Maske verhindert wird. Das teilweise Aushärten wird englisch "freezing" genannt, wovon sich der Ausdruck "gefreezed" ableitet.

Ein weiterer besonderer Vorteil besteht darin, dass eine wesentlich tiefere Ätzung vorgenommen werden kann, als dies bei Wachs oder herkömmlichen Masken, beispielsweise durch ein Siebdruckverfahren, möglich ist. Somit kann eine wesentlich verbesserte Oberflächenstruktur der Pressbleche beziehungsweise Endlosbänder hergestellt werden, die gegebenenfalls auch eine dreidimensionale Tiefenstruktur beinhaltet. Die hiermit hergestellten Pressbleche beziehungsweise Endlosbänder versetzen ferner die Abnehmer der Pressbleche in die Lage, exaktere Oberflächenstrukturen zu prägen, die darüber hinaus aufgrund der vorliegenden Digitalisierung der Maske identisch mit den verwendeten Dekorpapieren sind, sodass eine Oberflächengüte erzielt werden kann, die eine deckungskonforme Prägung zu den Dekorpapieren ermöglicht. Durch mehrere Druck- und Atzvorgänge besteht darüber hinaus die Möglichkeit, eine dreidimensionale Tiefenstruktur zu erzielen, die einer natürlichen Oberfläche, wie sie beispielsweise durch eine Holzstruktur vorgegeben wird, sehr nahe kommt.

Das Besondere des erfindungsgemäßen Verfahrens ist ferner, dass zwei Technologien miteinander verbunden werden, die bisher als unvereinbar galten. Bei der Wachstechnologie wurde die Maske direkt und ohne Umwege auf das Pressblech aufgetragen, wo hingegen die Siebdruckmaske, die mit Hilfe eines entwickelten UV-Lacks hergestellt wird, die vollständige Beschichtung der zu bearbeitenden Materialien erfordert und nach Auflage einer Maske, einer anschließenden Belichtung und Entwicklung der UV-Beschichtung in einem weiteren Schritt der nicht entwickelte Teil des UV-Lacks entfernt werden muss, bevor die Ätzung vorgenommen wird. Durch das erfindungsgemäße Verfahren werden die Vorzüge beider Verfahren mit einander kombiniert und eine hohe Auflösung der Oberflächenstruktur erzielt.

Während des Herstellens der Maske werden die Pressbleche beziehungsweise Endlosbänder in einer ebenen Position gehalten, sodass insbesondere sicher gestellt ist, dass der Abstand des Sprühkopfes zur Oberfläche der Pressbleche oder Endlosbänder konstant gehalten wird.

Erfindungsgemäß wird der Lack kurz nach Aufdruck oder Aufsprühen durch den Druckkopf so lange belichtet, dass der Lack teilweise aushärtet. Dadurch bleibt der Lack zur Handhabung flexibel, verläuft nicht und kann zum Abschluss des Verfahrens durch erneute Belichtung ausgehärtet werden. Um ein Verlaufen des UV-Lackes zu verhindern wird vorzugsweise ein UV-Lack mit reduzierten Lösungsmittelanteilen verwendet.

Um eine Perlbildung auf der Oberfläche zu vermeiden und die Fließfähigkeit bis zur Herstellung einzelner Maskenabschnitte beizubehalten, ist im Weiteren vorgesehen, dass der UV-Lack vor dem Auftragen vorgewärmt und bei konstanter Temperatur aufgetragen wird. Eine Temperierung von 50°C bis 100°C von Lack und/oder Pressblech hat sich hierbei als vorteilhaft erwiesen. Besonders gute Erfahrung wurden mit einer Temperatur von 65°C bis 75°C gemacht.

In besonderer Ausführungsform des erfindungsgemäßen Verfahrens wird der Lack, vorzugsweise ein UV-Lack des US-amerikanischen Unternehmens "Markem", auf 70°C vorgewärmt und optional auf eine temperierte Pressplatte durch Relativdruck aufgebracht.

Zur Herstellung der Maske kann ein Druckkopf, der im wesentlichen aus einem Sprühkopf mit einer Düsenmatrix besteht, verwendet werden oder der UV-Lack kann durch ein Druckverfahren aufgetragen werden, wobei nach dem Auftragen der Maske zumindest eine teilweise Bestrahlung der Maske mit einem UV-Licht erfolgt. Die Bestrahlung kann unmittelbar nach der Auftragung, speziell bei der Verwendung eines Sprühkopfes erfolgen, wobei innerhalb eines Zeitraums von bis zu 60 Sekunden der UV-Lack zunächst teilweise ausgehärtet wird, d. h. er wird an der Oberfläche ausgehärtet, ohne dass eine vollständige Durchhärtung des UV-Lacks erfolgt, sodass er elastisch bleibt und auch bei einem weiteren Handling genügend Elastizität besitzt, um bei Biegevorgängen der Bleche nicht abzuplatzen. Aus diesem Grund wird der UV-Lack nur teilweise ausgehärtet, wobei der Härtegrad durch die Dauer der UV-Bestrahlung und damit aufgebrachten Lichtintensität gesteuert werden kann.

Um ein Verlaufen des UV-Lacks der Maske durch einen zu hohen Lackauftrag in einem Arbeitsgang an einer Stelle zu verhindern, ist vorgesehen, dass die herzustellende Maske in mehreren versetzten Arbeitsgängen aufgebaut wird, wobei insbesondere eine Vielzahl von Einzeldüsen der Matrix beim Überfahren der Oberfläche angesprochen werden, sodass die aufgesprühten Punkte sich nach und nach zu einer Linienführung ergänzen und die gewünschte Maske ergeben. Hierzu wird eine zweidimensionale Matrix über das Substrat geführt. Diese Matrix wird so angesprochen, dass die gesamte Matrix mehrfach über einen zu druckenden kleinsten Punkt fährt. Dabei wird jeder zu druckende Punkt durch einen zufällig ausgewählten Matrixpunkt gedruckt. Wenn ein Druckkopf beispielsweise 256 Düsenköpfe aufweist, die als 16x16 Matrix ausgebildet sind und der Druckkopf zweimal so über einen zu druckenden Punkt fährt, dass er von verschiedenen Zeilen der Matrix überstrichen wird, so ergeben sich für den Druckpunkt 32 Möglichkeiten, von einer zufällig ausgewählten Düse gedruckt zu werden. Wird der Zeilenvorschub zusätzlich zufallsvariiert, so ergeben sich 16x16 gleich 256 Möglichkeiten, den Punkt aus einer einzigen Düse zu drucken. Die Zahl kann noch weiter erhöht werden, wenn mehr als eine Düse Tinte oder UV-Lack auf einen zu druckenden Punkt sprüht. Durch diese zufallsbedingte Auswahl des tatsächlich druckenden Düsenventils wird verhindert, dass sich feine Streifen oder Systemimmanente Druckfehler auf dem Pressblech abbilden, die durch imperfekte Mechanik oder durch minimale Erschütterungen während des Drucks entstehen können.

Eine besondere Problematik ergibt sich durch den Druck des Motivs auf eine polierte Oberfläche des Pressbleches. Hierdurch werden vagabundierende UV-Strahlen bei der Nachbelichtung auf den Druckkopf treffen und somit den Druckkopf durch abbindenden UV-Lack zerstören. Zur Vermeidung dieses Problems ergeben sich mehrere Lösungen, die zum Erfolg führen.

Zunächst ist es möglich, das Pressblech chemisch aufzurauhen, sodass das Pressblech stumpf erscheint. Hierdurch wird das Licht besser absorbiert und vagabundiert nicht in den Druckkopf.

Eine weitere Möglichkeit ist die Verwendung eines Filters, der nur solche UV-Strahlung passieren lässt, die vom Pressblechsubstat vollständig absorbiert wird.

Noch eine weitere Lösung hat sich als erfolgreich herausgestellt, die einer Verstopfung des Druckkopfes entgegen wirkt. Hierzu werden Laserdioden oder UV-Dioden verwendet, die nur in der kurzen Zeit einen Lichtpuls aussenden, in welcher der Druckkopf einen Pumpstoß durchführt. Während dieser Zeit absorbiert zwar am Kopf anhaftender Lack die Strahlung; diese wird aber sofort ausgestoßen und verweilt nicht auf dem Ventil, wo der Lack abbindet und den Kopf zerstört. Da in dem verwendeten Druckkopf alle Düsen regelmäßig Pumpstöße durchführen, existiert kein Ventil, das sich zusetzen kann.

Darüber hinaus existiert die Möglichkeit der Verwendung einer schwarzen Maske, die eine Rückreflexion des UV-Lichts verhindert, die Verwendung eines Lampenschirmes, der sehr dicht über der Oberfläche des teilzuhärtenden Substrats geführt wird und ein Nachlauf der UV-Lampe, der so gesteuert wird, dass UV-Lampe und Druckkopf nicht in unmittelbarer Nähe aktiv sind, wobei die UV-Lampe eigens geführt wird und dem Druckkopf entgegen oder nachläuft.

Zum Auftragen der Maske ist im weiterer Ausgestaltung der Erfindung vorgesehen, dass die Pressbleche oder Endlosbänder einer Vorbehandlung, beispielsweise einer mechanischen Säuberung und einer Reinigung mit Isopropanol, Ethanol oder Spiritus unterzogen werden und ggf. eine Vorbehandlung mit einem Primer, beispielsweise mit einer organischen Silylverbindung, erfolgt. Hierdurch wird erreicht, dass eine besonders gute Oberflächenhaftung entsteht und der UV-Lack unmittelbar auf die Pressbleche oder Endlosbänder aufgetragen werden kann. Zusätzlich kann die Oberfläche der Pressbleche oder Endlosbänder angeätzt werden. Der Druckkopf selbst wird beim Herstellen der Maske entlang der Längskante des herzustellenden Pressbleches oder Endlosbandes verfahren, wobei es sich vorzugsweise um die X-Achse handelt und zusätzlich zur Y-Achse, also senkrecht hierzu, hin und her bewegt, wobei die Schrittweite der Bewegung in Richtung der X-Achse der Matrixbreite abzüglich oder zuzüglich des Abstands von benachbarten Düsen der Matrix dividiert durch die Anzahl der Matrixzeilen entspricht, sodass während des Verfahrens entlang der Y-Achse durch die Einzeldüsen die Maske zum Teil aufgebaut wird und anschließend eine Bewegung entsprechend der Schrittweite zur X-Achse erfolgt, sodass nach einer Vielzahl von Schritten entlang der X-Achse der vollständige Aufbau der Maske mit einer hohen Auflösung erfolgen kann.

Im Anschluss an die Maskenerstellung wird zur chemischen Oberflächenbearbeitung eine herkömmliche bekannte Atztechnik eingesetzt und nach Beendigung des Ätzvorgangs kann die Oberfläche durch Abspülen mit einem Reinigungs- und Neutralisierungsmittel behandelt werden, wobei gleichzeitig ein Entfernen der aufgetragenen Maske ohne Schwierigkeiten erfolgen kann. Zur Entfernung von sich in Strukturtälern befindlichem UV-Lack wird zusätzlich ein Ultraschallschwinger verwendet, der durch Kavitation Lackreste aus den Strukturtälern löst.

Die Pressbleche oder Endlosbänder wurden zur Nachbehandlung mit einer Beschichtung versehen, wobei die Pressbleche oder Endlosbänder zur Nachbehandlung ganzflächig verchromt werden, vorzugsweise hart verchromt, oder mit diamantartigem Kohlenstoff oder mit Titanborid beschichtet werden.

Zur Durchführung des Verfahrens ist erfindungsgemäß eine Vorrichtung zum Auftragen und Aushärten einer Maske aus einem UV- aushärtbarem Lack auf einer Oberfläche eines metallischen Pressbleches oder Endlosbandes zur weiteren Oberflächenbearbeitung vorgesehen, wie sie in Anspruch 25 definiert wird. Die Steuereinheit dient hierbei dazu, mit Hilfe der Antriebselemente den Sprühkopf in die bestimmte Position zu verfahren, die durch das digitalisierte Abbild der herzustellenden Maske vorgegeben ist. Vorzugsweise wird hierbei eine Schlittenführung vorgesehen, die eine hohe reproduzierbare Genauigkeit zum Anfahren der jeweiligen Position gewährleistet und gleichzeitig sicherstellt, dass ein Verfahren des Sprühkopfes sowohl in x- als auch in y-Richtung möglich ist. Zur Einhaltung eines gleichbleibenden Abstands zur Oberfläche der zu bearbeitenden Materialien ist diese Schlittenführung unter Berücksichtigung der vorgesehenen Maximalgröße in der Art aufgebaut, dass eine Durchbiegung infolge des Eigengewichtes des Sprühkopfes ausgeschlossen ist. Um geringfügige Abstandsvaviationen durch Temperaturschwankung, minimaler Durchbiegung des Schlittenlaufes oder Verwerfung der Pressbleche oder Endlosbänder auszugleichen, ist vorgesehen, dass der Druckkopf durch eine Nivelliervorrichtung auf einen konstanten Abstand zur Oberfläche des Pressbleches durch Verfahren in z-Richtung gehalten wird, um so eine konstante Druckqualität zu erhalten. Hierdurch wird insbesondere sicher gestellt, dass der Abstand des Sprühkopfes zur Oberfläche der zu bearbeitenden Materialien konstant gehalten wird. Der Düsenkopf selbst ist mit einer Vielzahl von Düsen in Form einer Matrix ausgestattet, welche jeweils einzeln ansteuerbar sind und in einem geringen Abstand zur Oberfläche der zu bearbeitenden Materialien, von 0,1 - 4 mm, bevorzugt von 0,8 mm, geführt werden.

Damit das zu bearbeitende Material nicht während des Auftragens verrutschen kann und in einer exakten Position gehalten wird, ist die vorgesehene Auflageeinrichtung mit einer Planfläche versehen, wobei das zu bearbeitende Material zusätzlich durch ein Vakuum angesaugt wird.

Die Maske wird entsprechend dem vorgesehenen Verfahren durch mehrere versetzte Arbeitsgänge aufgebaut, wobei der Düsenkopf entlang einer x-Achse schrittweise verfahren wird und nach jedem Verfahrensschritt zunächst ein Verfahren des Düsenkopfes in Richtung der y-Achse erfolgt, bevor eine weitere Bewegung entlang der x- Achse vorgenommen wird. Zu diesem Zweck sind die Düsen des Düsenkopfes nebeneinander in einer x- und y-Richtung angeordnet, wobei die Düsen funktional zu Gruppen von jeweils mindestens zwei Düsen zusammengefasst sind und wobei die Düsen und/oder die Pressbleche oder Endlosbänder nach der Bearbeitung in Richtung einer x-Achse in eine neue Position bewegbar sind und die Schrittweite der Bewegung in Richtung der x-Achse der Gruppenbreite abzüglich oder zuzüglich des Abstands von benachbarten Düsen der Gruppen dividiert durch die Anzahl der Gruppen entspricht.

Zur teilweisen Aushärtung des aufgetragenen UV-Lacks ist der Düsenkopf mit einer UV-Lampe ausgestattet, welche unmittelbar nach Fertigstellung der abschnittweise aufgetragenen Maske den fertig gestellten Abschnitt belichtet, sodass zunächst der UV-Lack teilausgehärtet wird. Hierdurch wird der wesentliche Vorteil erzielt, dass ein Verlaufen des UV-Lacks verhindert und darüber hinaus eine Wischfestigkeit erzielt wird, die eine Zerstörung der aufgetragenen Maske während der weiteren Arbeitsvorgänge verhindert. Zur Vermeidung eines Abplatzens des UV-Lacks von der Oberfläche der Pressbleche oder Endlosbänder ist hierbei vorgesehen, dass keine vollständige Aushärtung erfolgt.

Die Auflageeinrichtung für die zu bearbeitenden Materialien wird hierbei in einer annähernd horizontalen oder vertikalen Position gehalten, wobei ggf. je nach vorgesehenem Einsatzzweck auch eine zur Vertikalen geneigte Position gewählt werden kann.

Um die Planarität der Auflagefläche einzuhalten, ist die Auflageeinrichtung mit einzelnen ebenen Teilflächen ausgestattet, wobei innerhalb der Teilflächen eine Ansaugöffnung vorhanden ist, die unmittelbar mit einer Vakuumsaugeinrichtung verbunden ist, sodass jede Teilfläche gleichzeitig als Auflagefläche und Ansaugfläche für das zu bearbeitende Material verwendet werden kann und eine über die gesamte Fläche des zu bearbeitenden Werkstückes gleichmäßige und ebene Anlage gewährleistet ist. Hierdurch werden unerwünschte Unplanaritäten ausgeglichen.

Der Düsenkopf weist im Weiteren eine Abschirmung auf, welche verhindert, dass die unvollständig aufgetragene Maske oder Einzelpunkte des Maskenaufbaus während der Bearbeitung bereits bestrahlt werden und somit aushärten können. Als UV-Lampe ist eine Quecksilberdampflampe beziehungsweise eine Xenonlampe vorgesehen, wobei ggf. auch UV-Power LEDs verwendet werden können, die aufgrund ihres eng begrenzten Abstrahlwinkels einen genau definierten Bereich der Maske bestrahlen und somit eine direkte Nachführung nach erfolgter Fertigstellung der Maske zusammen mit dem Sprühkopf ermöglichen. Es ist aber auch möglich auf gepulste Laser, auf Laser-Dioden, einfache UV-LED's oder Lampen mit einem Interferenz- oder gleichwirkenden Filter zu verwenden.

Der besondere Vorteil des Verfahrens ist der, dass mit hoher Präzision und Reproduzierbarkeit eine Maske mit Hilfe der erfindungsgemäßen Vorrichtung auf ein vorbehandeltes Pressblech oder Endlosband aufgetragen werden kann und durch den verwendeten UV-Lack eine schnelle Reinigung des Pressblechs oder Endlosbands zur weiteren Nachbearbeitung gewährleistet ist. Der UV-Lack selbst ist gegenüber den meisten Säuren beständig und eignet sich daher hervorragend zur Passivierung der Oberfläche, um einen anschließenden Ätzvorgang durchzuführen. Mit Hilfe einer EDV-gestützten Bewegung des Sprühkopfes wird hierbei die Genauigkeit und Reproduzierbarkeit im erforderlichen Umfang sicher gestellt, wobei insbesondere aufgrund einer digitalisierten Vorlage, die mit dem Druckbild eines Dekorpapiers zum späteren Einsatz der Pressbleche identisch ist, ein deckungskonformes Prägen ermöglicht wird, welches zu einer hervorragenden Oberflächenstruktur der mit den Pressblechen oder Endlosbändern behandelten Oberflächen führt.

Die Erfindung wird im Weiteren anhand der Figuren nochmals verdeutlicht

Es zeigt
- Fig. 1: in einer Draufsicht eine erfindungsgemäße Vorrichtung zur Bearbeitung eines Pressblechs und
- Fig. 2: eine geschnittene Darstellung ein Pressblech in verschiedenen Arbeitsschritten.

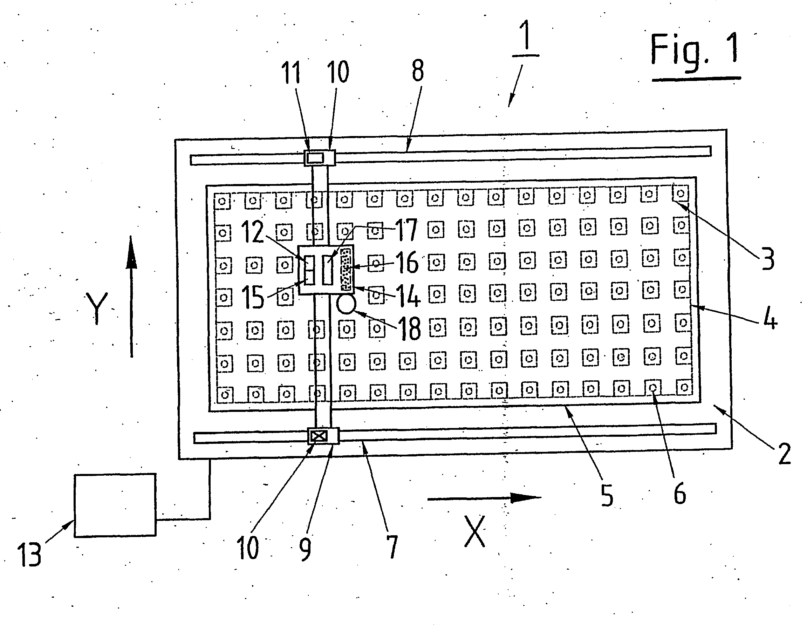

Figur 1 zeigt in einer Draufsicht eine Vorrichtung 1 zur Anwendung des erfindungsgemäßen Verfahrens. Die Vorrichtung besteht aus einem Auflagetisch 2 mit einer aus einer Vielzahl von einzelnen Planflächen 3 hergestellten Auflagefläche 4, auf der ein Pressblech 5 aufliegt. In den Planflächen 3 ist jeweils eine Ansaugöffnung 6 ausgebildet, die mit Hilfe einer nicht dargestellten Vakuumpumpe das Pressblech 5 auf die Planflächen 3 zieht und somit eine unverrückbare Position des Pressblechs 5 während des gesamten Arbeitsprozesses gewährleistet.

Im gezeigten Ausführungsbeispiel ist die Vorrichtung 1 in einer horizontalen Position angeordnet, es besteht jedoch ohne weiteres die Möglichkeit, diese in einer vertikalen Position oder in einer zur vertikal geneigten Position anzuordnen, um die Bearbeitung des Pressblechs 5 vorzunehmen. Entlang der größten Ausdehnung des Pressblechs 5 sind Führungsschienen 7, 8 ausgebildet, auf denen Gleitführungen 9, 10 entlang verfahrbar sind, und zwar mit Hilfe eines Antriebsmotors 11, 12, welche über eine Steuereinrichtung 13, vorzugsweise eine EDV-unterstützte Steuereinrichtung, angesteuert werden. Mit Hilfe der Antriebsmotoren 11, 12 wird der Sprühkopf 14 in Richtung der X-Achse und der Y-Achse schrittweise verfahren, wobei mit Hilfe eines weiteren Antriebsmotors 15 gegenüber der Z-Achse weitere Bewegungen zur Nivellierung des Sprühkopfes 14 erfolgen. Der Sprühkopf 14 selbst besteht im Wesentlichen aus der Düsenmatrix 16, aus einem Vorratsbehälter 17 für den aufzusprühenden Lack sowie zumindest einem Leuchtmittel 18, welches die zumindest teilweise fertig gestellte Maske nach einem definierten Zeitraum für eine bestimmte Zeit bestrahlt und somit zu einer zumindest teilweisen Aushärtung des UV-Lacks führt.

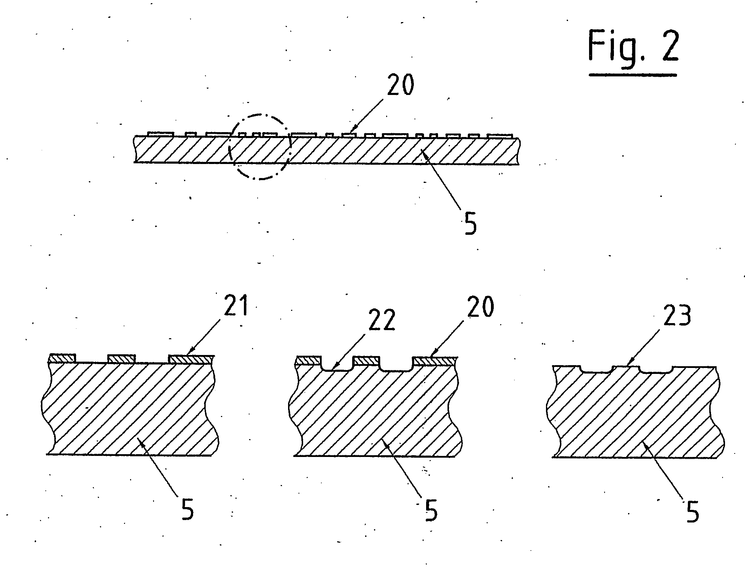

Figur 2 zeigt in einer vergrößerten geschnittenen Darstellung ein Pressblech 5 mit einer Maske 20, welche durch das beschriebene Verfahren und der Vorrichtung gemäß Figur 1 aufgetragen wurde. Aus der vergrößerten Darstellung gemäß der linken Teilfigur ist hierbei ersichtlich, dass der UV-beständige Lack 21 partiell auf dem Pressblech 5 aufgetragen wurde. Nach Durchführung des Ätzvorgangs, welcher durch die mittlere Teilfigur dargestellt ist, befindet sich die Maske 20 noch auf der Oberfläche des Pressblechs 5, jedoch wurden die Bereiche 22, die nicht durch die Maske abgedeckt sind, zum Teil ausgeätzt, sodass eine Vertiefung entstanden ist. Nach abschließender Reinigung, wie sie beispielsweise in der rechten Teilfigur dargestellt ist, besitzt das Pressblech 5 im gezeigten Ausführungsbeispiel einseitig eine Oberflächenstruktur 23, die nach erfolgter Reinigung und Entfernen der Maske 20 den Vorgaben des Kunden entspricht. Diese Oberflächenstruktur 23 kann ggf. durch weitere Ätzvorgänge in der Tiefe strukturiert, dass heißt dreidimensional, ausgeführt werden. Zusätzlich können beide Seiten des Pressblechs 5 in dieser Weise bearbeitet werden.

Zur Erreichung einer maximalen Auflösung bei der Erstellung der Maske wird ein weiteres Verfahren zur Steuerung der Düsen bei jedem Druckvorgang angewendet, wobei die Düsen funktional zu Gruppen zusammengefasst sind. Diese Gruppen können 2 - 4, aber auch ein vielfaches davon an Düsen umfassen, die nach einem einheitlichen Schema angesteuert werden. Hierbei wird zu einem beliebigen Zeitpunkt eine Überdeckung zwischen der ersten Gruppe von Düsen und dem Werkstück eingestellt, worauf der Sprühkopf entlang des Werkstücks einmal über seine ganze Länge in Y-Richtung relativ zum Werkstück verfährt und gleichzeitig UV-aushärtender Lack aus den Düsen aufgespritzt wird. Anschließend wird der Sprühkopf zu einem späteren Zeitpunkt in Richtung der X-Achse soweit bewegt, dass eine weitere ausgewählte Gruppe von Düsen sich mit der Oberfläche des Werkstücks überlappt, wobei die Schrittweite so gewählt wird, dass die Gruppenbreite der Düsen abzüglich des Abstands von benachbarten Düsen dividiert durch die Anzahl der Gruppen entspricht. Hierdurch wird gewährleistet, dass bei der zweiten Relativbewegung zwischen Druckkopf und Werkstück keine Überdeckung zwischen dem von der zweiten Gruppe erzeugten Muster und dem von der ersten Gruppe erzeugten Muster zustande kommt, sondern, dass sich diese mit der maximalen Auflösung ergänzen. Im Anschluss daran wird der Druckkopf wieder um die Gruppenbreite abzüglich des Abstands von benachbarten Düsen in Richtung der X-Achse verfahren. Danach findet wieder eine Relativbewegung zwischen Druckkopf und Werkstück über die gesamte Breite des Werkstücks in Richtung der Y-Achse statt, wodurch wiederum mit maximaler Auflösung ein benachbartes Muster vom UV-aushärtenden Lack auf das Werkstück aufgesprüht wird. Sobald die letzte Gruppe der Düsen nach Abschluss der Relativbewegung zwischen Druckkopf und Werkstück wieder um eine Schrittweite in Richtung der X-Achse verschoben wurde, ist die aus dem UV-aushärtenden Lack bestehende Maske entsprechend der ersten Gruppenbreite in maximaler Auflösung fertig gestellt. Mehrere dieser Gruppenbreiten schließen sich aneinander an und ergeben hierbei die gesamte fertig zu stellende Maske.

### Bezugszeichenliste

- 1: Vorrichtung
- 2: Auflagetisch
- 3: Planfläche
- 4: Auflagefläche
- 5: Pressblech
- 6: Ansaugöffnung
- 7: Führungsschiene
- 8: Führungsschiene
- 9: Gleitführung
- 10: Gleitführung
- 11: Antriebsmotor
- 12: Antriebsmotor
- 13: Steuereinrichtung
- 14: Sprühkopf
- 15: Antriebsmotor
- 16: Düsenmatrix
- 17: Vorratsbehälter
- 18: Leuchtmittel
- 20: Maske
- 21: Lack
- 22: Bereich
- 23: Oberflächenstruktur

## Patentansprüche

1. Verfahren zur Oberflächenstrukturierung eines metallischen Pressbleches (5) oder Endlosbandes, aufweisend die Schritte:
- Lagerung des Pressbleches (5) oder Endlosbandes auf einem Arbeitstisch (2) mit einer planen Oberfläche zum Auftragen und Aushärten einer Maske (20),
- Auftragen einer aus zumindest teilweise aushärtbarem UV-Lack bestehenden Maske zur partiellen Passivierung durch eine geeignete Vorrichtung (1) mittels eines digitalisierten Druckverfahrens,
- welche einen Sprühkopf (14) umfasst, der in einem geringen konstanten Abstand von 0,1 bis 4 mm zur Oberfläche der Pressbleche (5) oder Endlosbänder geführt wird,
- zumindest teilweise Bestrahlung der Maske (20) mit einer UV-Lichtquelle direkt nach der Auftragung zum Aushärten vorzugsweise in einem Zeitraum von bis zu 60 Sekunden,
- chemisches Bearbeiten der Oberfläche des Pressbleches (5) oder Endlosbandes.

2. Verfahren nach Anspruch 1,
**dadurch gekennzeichnet,**
**dass** der UV-Lack vor dem Auftragen vorgewärmt und bei konstanter Temperatur aufgetragen wird, wobei der UV-Lack vorzugsweise bei 50°C bis 100°C, besonders bevorzugt bei 65°C bis 75°C vorgehalten wird.

3. Verfahren nach Anspruch 1 oder 2,
**dadurch gekennzeichnet,**
**dass** der UV-Lack reduzierte Lösungsmittelanteile enthält.

4. Verfahren nach einem der Ansprüche 1 bis 3,
**dadurch gekennzeichnet,**
**dass** zur Auftragung des UV-Lacks ein Sprühkopf (14) in Form eines Düsenkopfes verwendet wird.

5. Verfahren nach Anspruch 4,
**dadurch gekennzeichnet,**
**dass** der Düsenkopf (14) mehrere Düsen aufweist, die in Form einer Matrix angeordnet sind und einzeln angesteuert werden.

6. Verfahren nach Anspruch 4 oder 5,
**dadurch gekennzeichnet,**
**dass** eine zufällige Auswahl der Düse aus der Matrix zum Druck eines vorgegebenen, zu druckenden Motivpunktes erfolgt, wobei diese Düse, wenn sie den Druckbereich überstreicht, den Punkt druckt und wobei auch mehr als eine zufällig ausgewählte Düse auf dem selben zu druckenden Punkt UV-Lack aufträgt.

7. Verfahren nach einem der Ansprüche 4 bis 6,
**dadurch gekennzeichnet,**
**dass** der Düsenkopf (14) in x- und/oder y-Richtung in einer Ebene und gegenüber der Ebene in z-Richtung verfahrbar ausgebildet ist oder der Düsenkopf (14) ortsfest gehalten nur in z-Richtung verfahrbar ist, während die Pressbleche (5) oder Endlosbänder gegenüber dem Düsenkopf (14) bewegt werden.

8. Verfahren nach einem der Ansprüche 4 bis 7,
**dadurch gekennzeichnet,**
**dass** der Düsenkopf (14) in einem Abstand von 0,8 mm zur Oberfläche der Pressbleche oder der Endlosbänder geführt wird, wobei eine automatische Nivelliereinrichtung den Düsenkopf im gewählten Abstand zum Pressblech (5) oder Endlosband führt.

9. Verfahren nach einem der Ansprüche 4 bis 8,
**dadurch gekennzeichnet,**
**dass** der Düsenkopf (14) die aufzutragende Maske (20) in mehreren versetzten Arbeitsgängen aufbaut.

10. Verfahren nach einem der Ansprüche 4 bis 9,
**dadurch gekennzeichnet,**
**dass** die Düsen des Düsenkopfes (14) nebeneinander in einer X-und Y-Richtung angeordnet sind und der Düsenkopf (14) in Richtung einer X-und Y-Achse bewegt wird, wobei die Düsen funktional zu Gruppen von jeweils zumindest zwei Düsen zusammengefasst werden, und wobei die Düsen und/oder die Pressbleche (5) oder Endlosbänder nach der Bearbeitung in Richtung der Y-Achse in eine neue Position zur X-Achse bewegt werden und die Schrittweite der Bewegung in Richtung der X-Achse der Breite der Düsenmatrix abzüglich oder zuzüglich des Abstandes von benachbarten Düsen der Matrix dividiert durch die Anzahl der Düsen in einer Reihe entspricht.

11. Verfahren nach einem der Ansprüche 1 bis 10,
**gekennzeichnet durch**
eine UV-Lichtquelle, welche ausschließlich in der Zeit UV-Licht aussendet, in der auch der Düsenkopf Material zum Druck der Maske aufsprüht.

12. Verfahren nach einem der Ansprüche 1 bis 11,
**gekennzeichnet durch**
die Verwendung einer schwarzen Maske für die UV-Lampe und/oder eines Lampenschirms zur Verhinderung von Reflexionen.

13. Verfahren nach einem der Ansprüche 1 bis 12,
**gekennzeichnet durch**
die Verwendung eines Lichtfilters für die UV-Lampe, das kurzwelliges Licht nicht passieren lässt, wobei die Absorptionskante so gewählt ist, dass das passierende Licht vollständig vom Material des Pressbleches (5) oder Endlosbandes absorbiert wird.

14. Verfahren nach einem der Ansprüche 1 bis 13,
**dadurch gekennzeichnet,**
**dass** die Pressbleche (5) oder Endlosbänder in einer horizontalen oder vertikalen Position bearbeitet werden.

15. Verfahren nach einem der Ansprüche 1 bis 14,
**dadurch gekennzeichnet,**
**dass** die Pressbleche (5) durch ein Vakuum angesaugt werden.

16. Verfahren nach einem der Ansprüche 1 bis 15,
**dadurch gekennzeichnet,**
**dass** die Pressbleche (5) oder Endlosbänder einer Vorbehandlung unterzogen werden.

17. Verfahren nach einem der Ansprüche 1 bis 16,
**dadurch gekennzeichnet,**
**dass** zur Vorbehandlung eine mechanische Säuberung und eine Reinigung mit Isopropanol, Ethanol oder Spiritus erfolgt und/oder eine Behandlung mit einem Primer, beispielsweise eine organische Silyl-Verbindung, erfolgt.

18. Verfahren nach einem der Ansprüche 1 bis 17,
**dadurch gekennzeichnet,**
**dass** die Oberfläche der Pressbleche (5) oder Endlosbänder vor dem Auftragen der Maske geätzt wird.

19. Verfahren nach einem der Ansprüche 1 bis 18,
**dadurch gekennzeichnet,**
**dass** das Pressblech einer chemischen Vorbehandlung unterzogen wird, welche eine stumpfe Oberfläche zur Vermeidung der Lichtreflexion erzeugt.

20. Verfahren nach einem der Ansprüche 1 bis 19,
**gekennzeichnet durch**
dass zur chemischen Oberflächenstrukturierung eine Ätztechnik eingesetzt wird.

21. Verfahren nach einem der Ansprüche 1 bis 20,
**gekennzeichnet durch**
dass nach Beendigung des Ätzvorganges die Maske **durch** ein Lösemittel entfernt wird.

22. Verfahren nach Anspruch 21,
**gekennzeichnet durch**
eine Unterstützung der Maskenentfernung **durch** Ultraschall.

23. Verfahren nach einem der Ansprüche 1 bis 22,
**dadurch gekennzeichnet,**
**dass** die Pressbleche (5) oder Endlosbänder zur Nachbehandlung mit einer Beschichtung versehen werden.

24. Verfahren nach einem der Ansprüche 1 bis 23,
**dadurch gekennzeichnet,**
**dass** die Pressbleche (5) oder Endlosbänder zur Nachbehandlung ganzflächig verchromt werden, vorzugsweise hart verchromt, oder mit diamantartigem Kohlenstoff oder mit Titanborid beschichtet werden.

25. Vorrichtung zum Auftragen und Aushärten einer Maske aus einem UVaushärtbarem Lack auf einer Oberfläche eines metallischen Pressbleches oder Endlosbandes zur weiteren Oberflächenbearbeitung, umfassend einen Arbeitstisch (2) mit einer planen Oberfläche für die zu bearbeitenden Pressbleche oder Endlosbänder, einem Sprühkopf, wobei der Sprühkopf durch eine Steuereinheit (13) und Schlittenführung (10) zur Bewegung des Sprühkopfes in eine beliebige Position innerhalb einer durch eine x- und y- Koordinate aufgespannte Ebene sowie unabhängige Antriebselemente (11, 12, 15) zur Anfahren der Position verfahrbar ist, wobei der Sprühkopf aus einem Düsenkopf zum Auftragen eines aushärtenden UV-Lackes besteht und der Düsenkopf mit einer UV-Lichtquette ausgestattet ist, welche nach vollständiger Fertigstellung der abschnittsweise aufgetragenen Maske den fertig gestellten Abschnitt bestrahlt, wobei
der Sprühkopf gegenüber der zur bearbeitenden Oberfläche, aufgespannt durch die x- und y-Koordinate zusätzlich in z-Richtung durch eine Nivelliervorrichtung auf einem geringen konstanten Abstand von 0,1 bis 4 mm zur Oberfläche der Pressbleche oder Endlosbänder durch Verfahren in z-Richtung geführt wird.

26. Vorrichtung nach Anspruch 25,
**dadurch gekennzeichnet,**
**dass** der Düsenkopf (14) mehrere Düsen aufweist, die in Form einer Matrix angeordnet sind und jeweils einzeln ansteuerbar sind.

27. Vorrichtung nach Anspruch 25 oder 26,
**dadurch gekennzeichnet,**
**dass** der Düsenkopf (14) in einem Abstand von 0,8 mm zur Oberfläche der Pressbleche (5) oder Endlosbänder geführt ist, wobei die Führung durch eine automatische Nivelliervorrichtung unterstützt wird.

28. Vorrichtung nach Anspruch 25, 26 oder 27,
**dadurch gekennzeichnet,**
**dass** der Düsenkopf (14) die aufzutragende Maske (20) durch mehrere versetzte Arbeitsgänge aufbaut.

29. Vorrichtung nach einem der Ansprüche 24 bis 28,
**dadurch gekennzeichnet,**
**dass** die Düsen des Düsenkopfes nebeneinander in einer X- und Y-Richtung angeordnet sind und der Düsenkopf (14) in Richtung einer X-und Y-Achse bewegbar ist, wobei die Düsen funktional zu Gruppen von jeweils zumindest zwei Düsen zusammengefasst sind und wobei die Düsen und/oder die Pressbleche (5) oder Endlosbänder nach der Bearbeitung in Richtung der Y-Achse in eine neue Position zur X-Achse bewegbar sind und die Schrittweite der Bewegung in Richtung der X-Achse der Breite der Düsenmatrix abzüglich oder zuzüglich des Abstandes von benachbarten Düsen der Matrix (20) dividiert durch die Anzahl der Gruppenzeilen entspricht.

30. Vorrichtung nach einem der Ansprüche 24 bis 29,
**dadurch gekennzeichnet,**
**dass** der Düsenkopf (14) eine Abschirmung aufweist, welche verhindert, dass die unvollständig aufgetragene Maske (20) oder einzelne Punkte des Maskenaufbaus während der Bearbeitung aushärten.

31. Vorrichtung nach einem der Ansprüche 24 bis 30,
**dadurch gekennzeichnet,**
**dass** der Arbeitstisch (2) zumindest annähernd in einer horizontalen oder vertikalen Position ausgerichtet ist.

32. Vorrichtung nach einem der Ansprüche 24 bis 31,
**dadurch gekennzeichnet,**
**dass** der Arbeitstisch (2) eine ebene Planfläche (3) aufweist, welche in eine Vielzahl von Teilflächen unterteilt ist und innerhalb der Teilflächen über Ansaugöffnungen (6) für eine Vakuumansaugeinrichtung verfügt.

33. Vorrichtung nach einem der Ansprüche 24 bis 32,
**dadurch gekennzeichnet,**
**dass** als UV-Lichtquelle eine Quecksilberdampflampe, Xenonlampe oder UV-Power-LEDs, Laserdioden oder ein Laser vorgesehen ist.

34. Vorrichtung nach einem der Ansprüche 24 bis 33,
**dadurch gekennzeichnet,**
**dass** als UV-Lichtquelle ein gepulster Laser vorgesehen ist, der ausschließlich dann Licht aussendet, wenn der Druckkopf Material zum Druck der Maske aufsprüht.

35. Vorrichtung nach einem der Ansprüche 24 bis 34,
**dadurch gekennzeichnet,**
**dass** eine schwarze Maske und/oder ein Lampenschirm zur Abschirmung des Druckkopfes vorgesehen ist, welcher ungewünschte Lichtreflexionen zum Druckkopf unterbindet.

36. Vorrichtung nach einem der Ansprüche 24 bis 35,
**dadurch gekennzeichnet,**
**dass** die UV-Lichtquelle oder die UV-Lampe dem Druckkopf in einigem Abstand folgt oder ihm entgegen läuft, wobei die UV-Lichtquelle oder die UV-Lampe in der Nähe des Druckkopfes, wenn sich Druckkopf und Lichtquelle treffen, ausgeschaltet ist.

## Claims

1. Method of surface structuring a metallic pressing plate (5) or a continuous belt, comprising the steps of:
- placing the pressing plate (5) or the continuous belt on a working table (2) with a plane surface for applying and curing a mask (20),
- applying a mask consisting of an at least partially curable UV varnish for partial passivation by a suited device (1) by means of a digitalized printing method,
- comprising a spray head (14) which is guided at a small constant distance of 0.1 to 4 mm to the surface of the pressing plates (5) or the continuous belts,
- at least partially irradiating the mask (20) with a UV light source directly after its application, preferably within a period of up to 60 seconds,
- chemically treating the surface of the pressing plate (5) or the continuous belt.

2. Method according to claim 1,
**characterized in that**
the UV varnish is preheated before its application and is applied at a constant temperature, the UV varnish being preferably supplied at 50°C to 100°C, particularly preferred at 65°C to 75°C.

3. Method according to claim 1 or 2,
**characterized in that**
the UV varnish contains reduced solvent proportions.

4. Method according to one of claims 1 to 3,
**characterized in that**
for the application of the UV varnish, a spray head (14) in the form of a nozzle head is used.

5. Method according to claim 4,
**characterized in that**
the nozzle head (14) comprises several nozzles which are arranged in the form of a matrix and are controlled individually.

6. Method according to claim 4 or 5,
**characterized in that**
the nozzle is arbitrarily selected from the matrix for printing a given motive dot to be printed, this nozzle, passing over the print area, printing the dot and more than one arbitrarily selected nozzle also applying UV varnish onto the same dot to be printed.

7. Method according to one of claims 4 to 6,
**characterized in that**
the nozzle head (14) is designed to be movable in the x- and/or y-direction in a plane and with respect to the plane in the z-direction, or the nozzle head (14) is, while it is held stationarily, only movable in the z-direction, while the pressing plates (5) or the continuous belts are moved with respect to the nozzle head (14).

8. Method according to one of claims 4 to 7,
**characterized in that**
the nozzle head (14) is guided at a distance of 0.8 mm to the surface of the pressing plates or the continuous belts, an automatic levelling means guiding the nozzle head at the selected distance to the pressing plate (5) or continuous belt.

9. Method according to one of claims 4 to 8,
**characterized in that**
the nozzle head (14) builds up the mask (20) to be applied in several staggered operations.

10. Method according to one of claims 4 to 9,
**characterized in that**
the nozzles of the nozzle head (14) are arranged next to each other in an X-and Y-direction, and the nozzle head (14) is moved in the direction of an X-and Y-axis, the nozzles being functionally combined to groups of at least two nozzles each, and wherein the nozzles and/or the pressing plates (5) or continuous belts are moved, after they have been worked, in the direction of the Y-axis to a new position to the X-axis, and the step size of the movement in the direction of the X-axis corresponds to the width of the nozzle matrix minus or plus the distance to adjacent nozzles of the matrix divided by the number of nozzles in one row.

11. Method according to one of claims 1 to 10,
**characterized by**
a UV light source which emits UV light exclusively during the time during which the nozzle head sprays on material for printing the mask.

12. Method according to one of claims 1 to 11,
**characterized by**
the use of a black mask for the UV lamp and/or a lamp shade for preventing reflexions.

13. Method according to one of claims 1 to 12,
**characterized by**
the use of a light filter for the UV lamp which does not allow short-wave light to pass, wherein the absorption edge is selected such that the passing light is completely absorbed by the material of the pressing plate (5) or continuous belt.

14. Method according to one of claims 1 to 13,
**characterized in that**
the pressing plates (5) or continuous belts are processed in a horizontal or vertical position.

15. Method according to one of claims 1 to 14,
**characterized in that**
the pressing plates (5) are sucked up by a vacuum.

16. Method according to one of claims 1 to 15,
**characterized in that**
the pressing plates (5) or continuous belts are subjected to a pretreatment.

17. Method according to one of claims 1 to 16,
**characterized in that**
for the pretreatment, mechanical cleaning and cleaning with isopropanol, ethanol or spirits is performed, and/or a treatment with a primer, for example an organic silyl compound, is performed.

18. Method according to one of claims 1 to 17,
**characterized in that**
the surface of the pressing plates (5) or continuous belts is etched before the mask is applied.

19. Method according to one of claims 1 to 18,
**characterized in that**
the pressing plate is subjected to chemical pretreatment generating a dull surface to avoid light reflexion.

20. Method according to one of claims 1 to 19,
**characterized in that**
for chemical surface structuring, an etching technique is employed.

21. Method according to one of claims 1 to 20,
**characterized in that**
after the termination of the etching process, the mask is removed by a solvent.

22. Method according to claim 21,
**characterized by**
supporting the mask removal by ultrasonic sound.

23. Method according to one of claims 1 to 22,
**characterized in that**
the pressing plates (5) or continuous belts are provided with a coating for post-treatment.

24. Method according to one of claims 1 to 23,
**characterized in that**
the pressing plates (5) or the continuous belts are chromium-plated all-over for post-treatment, preferably hard-chromium plated, or are coated with adamantine carbon or with titanium boride.

25. Device for applying and curing a mask of a UV curable varnish onto a surface of a metallic pressing plate or continuous belt for further surface processing, comprising a working table (2) with a plane surface for the pressing plates or continuous belts to be processed by means of a spray head, wherein the spray head can be moved, by a control unit (13) and a carriage guide (10), into any arbitrary position within a plane spanned by an x- and an y-coordinate by means of independent drive elements (11, 12, 15), consisting of a nozzle head for applying a curing UV varnish and a UV light source which irradiates the completed section upon completion of the mask that was applied in sections, **characterized in that** the spray head can be additionally moved in the z-direction with respect to the surface to be processed spanned by the x- and the y-coordinate by means of a control unit at a small constant distance of 0.1 to 4 mm to the surface of the pressing plates or continuous belts.

26. Device according to claim 25,
**characterized in that**
the nozzle head (14) comprises several nozzles which are arranged in the form of a matrix and can be controlled each individually.

27. Device according to claim 25 or 26,
**characterized in that**
the nozzle head (14) is guided at a distance of 0.8 mm to the surface of the pressing plates (5) or the continuous belts, guiding being supported by an automatic levelling device.

28. Device according to claim 25, 26 or 27,
**characterized in that**
the nozzle head (14) builds up the mask (20) to be applied by several staggered operations.

29. Device according to one of claim 24 to 28,
**characterized in that**
the nozzles of the nozzle head are arranged next to each other in an X- and Y-direction, and the nozzle head (14) is movable in a direction of an X- and an Y-axis, the nozzles being functionally combined to groups of at least two nozzles, and the nozzles and/or the pressing plates (5) or continuous belts being moved, after they have been worked, in the direction of the Y-axis to a new position to the X-axis, and the step size of the movement in the direction of the X-axis corresponding to the width of the nozzle matrix minus or plus the distance of adjacent nozzles of the matrix divided by the number of group lines.

30. Device according to one of claims 24 to 29,
**characterized in that**
the nozzle head (14) comprises a shield which prevents the incompletely applied mask (20) or individual dots of the mask build-up from curing during processing.

31. Device according to one of claims 24 to 30,
**characterized in that**
the working table (2) is at least approximately oriented in a horizontal or vertical position.

32. Device according to one of claims 24 to 31,
**characterized in that**
the working table (2) comprises a plane end face (3) which is divided into a plurality of partial areas and has suction holes (6) for a vacuum suction means within the partial areas.

33. Device according to one of claims 24 to 32,
**characterized in that**
as a UV light source, a mercury vapour lamp, a xenon lamp or UV power LEDs, laser diodes, or a laser is provided.

34. Device according to one of claims 24 to 33,
**characterized in that**
as a UV light source, a pulsed laser is provided which emits light only while the print head is spraying on material to print the mask.

35. Device according to one of claims 24 to 34,
**characterized in that**
a black mask and/or a lamp shade is provided for shielding the print head, preventing undesired light reflexions to the print head.

36. Device according to one of claims 24 to 35,
**characterized in that**
the UV light source or the UV lamp follows the print head at some distance or comes towards it, the UV light source or the UV lamp being switched off near the print head, when the print head and the light source meet.

## Revendications

1. Procédé de structuration de surface d'une tôle métallique emboutie (5) ou d'une bande sans fin, comportant les étapes suivantes :
- positionnement de la tôle emboutie (5) ou de la bande sans fin sur une table de travail (2) avec une surface plane pour l'application et le durcissement d'un masque (20),
- application d'un masque constitué au moins partiellement d'un vernis UV durcissable pour la passivation partielle par un dispositif adéquat (1) au moyen d'un procédé d'impression numérique,
- qui comporte une tête de pulvérisation (14), qui est guidée à une faible distante constante de 0,1 à 4 mm par rapport à la surface des tôles embouties (5) ou des bandes sans fin,
- irradiation au moins partielle du masque (20) avec une source lumineuse d'UV immédiatement après l'application, préférentiellement pendant une durée allant jusqu'à 60 secondes,
- traitement chimique de la surface de la tôle emboutie (5) ou de la bande sans fin.

2. Procédé selon la revendication 1, **caractérisé par le fait que** le vernis UV est préchauffé avant l'application et appliqué à température constante, le vernis UV étant maintenu préférentiellement de 50°C à 100°C, très préférentiellement de 65°C à 75°C.

3. Procédé selon la revendication 1 ou 2, **caractérisé par le fait que** le vernis UV contient des fractions de solvant réduites.

4. Procédé selon une des revendications 1 à 3, **caractérisé par le fait qu'**une tête de pulvérisation (14) est utilisée sous la forme d'une tête de buse pour l'application du vernis UV.

5. Procédé selon la revendication 4, **caractérisé par le fait que** la tête de buse (14) présente plusieurs buses qui sont disposées sous la forme d'une matrice et qui sont pilotées individuellement.

6. Procédé selon la revendication 4 ou 5, **caractérisé par le fait qu'**une sélection aléatoire de la buse depuis la matrice est effectuée pour imprimer un point de motif déterminé à imprimer, cette buse, quand elle recouvre la zone d'impression, imprimant le point et plus d'une buse sélectionnée aléatoirement appliquant également le vernis UV sur le même point à imprimer.

7. Procédé selon une des revendications 4 à 6, **caractérisé par le fait que** la tête de buse (14) est formé de manière déplaçable le long d'un axe x et/ou y dans un plan et par rapport au plan d'un axe z ou que la tête de buse (14) maintenue fixe n'est déplaçable que le long de l'axe z, tandis que les tôles embouties (5) ou les bandes sans fin peuvent être déplacées par rapport à la tête de buse (14).

8. Procédé selon une des revendications 4 à 7, **caractérisé par le fait que** la tête de buse (14) est guidée à une distance de 0,8 mm par rapport à la surface des tôles embouties ou des bandes sans fin, un dispositif de nivellement automatique guidant la tête de buse à la distance choisie par rapport à la tôle emboutie (5) ou à la bande sans fin.

9. Procédé selon une des revendications 4 à 8, **caractérisé par le fait que** la tête de buse (14) confectionne le masque (20) à appliquer en plusieurs tâches effectuées en décalage.

10. Procédé selon une des revendications 4 à 9, **caractérisé par le fait que** les buses de la tête de buse (14) sont disposées côte à côte dans des axes X et Y et que la tête de buse (14) est mobile dans des axes X et Y, les buses étant rassemblées de manière fonctionnelle en groupes individuels d'au moins deux buses, et les buses et/ou les tôles embouties (5) ou les bandes sans fin étant déplacées après le traitement dans l'axe Y dans une nouvelle position par rapport à l'axe X et le pas du déplacement en direction de l'axe X correspondant à la largeur de la matrice de buses en déduisant ou en ajoutant la distance par rapport aux buses adjacentes de la matrice divisée par le nombre de buses dans une rangée.

11. Procédé selon une des revendications 1 à 10, **caractérisé par** une source lumineuse d'UV, qui émet exclusivement durant cette période de la lumière UV, durant laquelle la tête de buse pulvérise également un matériau destiné à l'impression du masque.

12. Procédé selon une des revendications 1 à 11, **caractérisé par** l'utilisation d'un masque noir pour la lampe à UV et/ou d'un écran destiné à éviter toute réflexion.

13. Procédé selon une des revendications 1 à 12, **caractérisé par** l'utilisation d'un filtre à rayons pour la lampe à UV, qui ne laisse pas passer la lumière à ondes courtes, l'arête d'absorption étant choisie de telle sorte que la lumière passante soit totalement absorbée par le matériau de la tôle emboutie (5) ou de la bande sans fin.

14. Procédé selon une des revendications 1 à 13, **caractérisé par le fait que** les tôles embouties (5) ou les bandes sans fin sont traitées dans une position horizontale ou verticale.

15. Procédé selon une des revendications 1 à 14, **caractérisé par le fait que** les tôles embouties (5) sont aspirées par un vide.

16. Procédé selon une des revendications 1 à 15, **caractérisé par le fait que** les tôles embouties (5) ou les bandes sans fin sont soumises à un traitement préalable.

17. Procédé selon une des revendications 1 à 16, **caractérisé par le fait qu'**un décrassage mécanique et un nettoyage à l'isopropanol, à l'éthanol ou à l'alcool à brûler est effectué pour le traitement préalable et/ou un traitement est effectué avec une couche de fond, par exemple un composé silylé organique.

18. Procédé selon une des revendications 1 à 17, **caractérisé par le fait que** la surface des tôles embouties (5) ou des bandes sans fin est décapée avant l'application du masque.

19. Procédé selon une des revendications 1 à 18, **caractérisé par le fait que** la tôle emboutie est soumise à un traitement chimique préalable, qui produit une surface émoussée évitant la réflexion de la lumière.

20. Procédé selon une des revendications 1 à 19, **caractérisé par le fait qu'**une technique de décapage est utilisée pour la structuration chimique de surface.

21. Procédé selon une des revendications 1 à 20, **caractérisé par le fait que** le masque est retiré avec un solvant après l'achèvement du processus de décapage.

22. Procédé selon la revendication 21, **caractérisé par** une assistance du retrait du masque par ultrasons.

23. Procédé selon une des revendications 1 à 22, **caractérisé par le fait que** les tôles embouties (5) ou les bandes sans fin sont dotées d'un revêtement pour un traitement ultérieur.

24. Procédé selon une des revendications 1 à 23, **caractérisé par le fait que** les tôles embouties (5) ou les bandes sans fin sont couvertes de chrome, préférentiellement de chrome dur, sur la totalité de la surface pour le traitement ultérieur, ou sont revêtues d'un carbone de type diamant ou de borure de titane.

25. Dispositif destiné à appliquer et à durcir un masque constitué d'un vernis durcissable par UV sur une surface d'une tôle métallique emboutie ou d'une bande sans fin pour la poursuite du traitement de surface, comprenant une table de travail (2) avec une surface plane pour les tôles embouties ou les bandes sans fin à traiter au moyen d'une tête de pulvérisation, la tête de pulvérisation pouvant être déplacée par une unité de commande (13) et une glissière de chariot (10) dans une position quelconque à l'intérieur d'un plan tendu par les axes x et y par des éléments d'entraînement indépendants (11, 12, 15), qui est constituée d'une tête de buse destinée à l'application d'un vernis durcissable par UV et d'une source lumineuse d'UV, qui irradie la section achevée après l'achèvement total du masque appliqué par sections, **caractérisé par le fait que** la tête de pulvérisation peut être déplacée, de surcroît le long de l'axe z, par rapport à la surface à traiter tendue le long des axes x et y, par une unité de commande à une faible distance constante de 0,1 à 4 mm par rapport à la surface des tôles embouties ou des bandes sans fin.

26. Dispositif selon la revendication 25, **caractérisé par le fait que** la tête de buse (14) présente plusieurs buses qui sont disposées sous la forme d'une matrice et peuvent être pilotées individuellement.

27. Dispositif selon la revendication 25 ou 26, **caractérisé par le fait que** la tête de buse (14) est guidée à une distance de 0,8 mm par rapport à la surface des tôles embouties (5) ou des bandes sans fin, le guidage étant assisté par un dispositif de nivellement automatique.

28. Dispositif selon la revendication 25, 26 ou 27, **caractérisé par le fait que** la tête de buse (14) constitue le masque à appliquer (20) par plusieurs tâches effectuées en décalage.

29. Procédé selon une des revendications 24 à 28, **caractérisé par le fait que** les buses de la tête de buse sont disposées côte à côte le long des axes X et Y et que la tête de buse (14) est mobile le long des axes X et Y, les buses étant rassemblées de manière fonctionnelle en groupes individuels d'au moins deux buses, et les buses et/ou les tôles embouties (5) ou les bandes sans fin pouvant être déplacées après le traitement le long de l'axe Y dans une nouvelle position par rapport à l'axe X et le pas du déplacement en direction de l'axe X correspondant à la largeur de la matrice de buses en déduisant ou en ajoutant la distance par rapport aux buses adjacentes de la matrice (20) divisée par le nombre de lignes de groupes.

30. Procédé selon une des revendications 24 à 29, **caractérisé par le fait que** la tête de buse (14) présente une protection empêchant que le masque appliqué de manière incomplète (20) ou que des points individuels de la structure de masque durcisse pendant le traitement.

31. Procédé selon une des revendications 24 à 30, **caractérisé par le fait que** la table de travail (2) est orientée au moins approximativement en position horizontale ou verticale.

32. Procédé selon une des revendications 24 à 31, **caractérisé par le fait que** la table de travail (2) présente une surface plane (3), qui est divisée en une multitude de surfaces partielles et dispose, à l'intérieur des surfaces partielles, d'ouvertures d'aspiration (6) pour un dispositif d'aspiration à vide.

33. Procédé selon une des revendications 24 à 32, **caractérisé par le fait qu'**une lampe à vapeur de mercure, une lampe au xénon ou des LED haute puissance UV, des diodes laser ou un laser sont prévues comme source lumineuse d'UV.

34. Procédé selon une des revendications 24 à 33, **caractérisé par le fait qu'**un laser pulsé est prévu comme source lumineuse d'UV, qui émet de la lumière exclusivement quand la tête d'impression pulvérise du matériau destiné à l'impression du masque.

35. Procédé selon une des revendications 24 à 34, **caractérisé par le fait qu'**un masque noir et/ou un écran destinés à protéger la tête d'impression sont prévus, qui empêchent les réflexions de lumière non sollicitées sur la tête d'impression.

36. Procédé selon une des revendications 24 à 35, **caractérisé par le fait que** la source lumineuse d'UV ou la lampe UV suit la tête d'impression sur une certaine distance ou vient à sa rencontre, la source lumineuse d'UV ou la lampe UV à proximité de la tête d'impression étant mise hors service quand la tête d'impression et la source lumineuse se rencontrent.
